## Europäisches Patentamt

## European Patent Office

## Office européen des brevets

(11) Veröffentlichungsnummer: **0 324 352 A2**

# EUROPÄISCHE PATENTANMELDUNG

(21) Anmeldenummer: **89100050.7**

(22) Anmeldetag: **03.01.89**

(51) Int. Cl.⁴: **H05K 3/44**

(30) Priorität: **08.01.88 DE 3800348**

(43) Veröffentlichungstag der Anmeldung:
**19.07.89 Patentblatt 89/29**

(84) Benannte Vertragsstaaten:
**AT BE CH DE FR GB IT LI LU NL SE**

(71) Anmelder: **Siemens Aktiengesellschaft Berlin und München**
**Wittelsbacherplatz 2**
**D-8000 München 2(DE)**

(72) Erfinder: **Hadwiger, Helmut Dipl.-Ing.**
**Friedrich-Herschel-Strasse 5**
**D-8000 München 80(DE)**
Erfinder: **Schmidt, Hans-Friedrich, Dr.-Ing.**
**Graf-Tattenbachweg 3**
**D-8196 Eurasburg(DE)**

(54) **Verfahren zur Herstellung einer Metallkernleiterplatte.**

(57) 1. Verfahren zur Herstellung einer Metallkernleiterplatte.

2.1. Herstellung von zwei- bzw. dreidimensionalen Metallkernleiterplatten beliebiger Form mit und ohne Durchkontaktierungen.

2.2 Die Herstellung derartiger Leiterplatten kann im Spritzgießverfahren, Spritzprägeverfahren oder in einem Preßverfahren erfolgen. Als Leiterplattenwerkstoff kommen dabei vorzugsweise hochwärmebeständige Thermoplaste, aber auch Duroplaste zum Einsatz. Für den Kern wird ein gut wärmeleitfähiges Metall eingesetzt. Bei der Materialauswahl ist darauf zu achten, daß die Wärmeausdehnungskoeffizienten von Metallkern- und Leiterplattenwerkstoff möglichst gleich sind. Die Herstellung beinhaltet folgende Verfahrensschritte:
ein- oder beidseitige Kaschierung der Metallplatte mit einer Kunststoffolie Einbringen des gewünschten Lochbildes mit entsprechendem Übermaß in die kaschierte Metallplatte Einlegen des derart vorbereiteten Metallkerns in das Spritzgießwerkzeug.

2.3. Automatisierungsgeräte.

## Metallkernleiterplatte und Verfahren zu deren Herstellung

Die Erfindung betrifft ein Verfahren nach dem Oberbegriff des Anspruchs 1 und eine Metallkernleiterplatte nach dem Oberbegriff des Anspruches 11.

Bei hochintegrierten Bauelementen bzw. Leistungsbauelementen ist die Abfuhr der in den Bauelementen gebildeten Wärme ein wesentliches Problem, das mit dem Einbau eines Metallkernes in die Leiterplatte und der damit verbundenen besseren Wärmeleitfähigkeit der Leiterplatte gelöst werden kann.

Die bisher für Metallkernplatten verwendeten Herstellungsverfahren sind:
- Beschichtung des Metallkernes mit Epoxid-Harzpulver durch Wirbelsintern
- Elektrostatische Beschichtung des Metallkernes
- Elektrophoretische Beschichtung des Metallkernes
- Tauchbeschichtung des Metallkernes
- Kernlaminierung

Diese Verfahren und ihre Vor- bzw. Nachteile sind in G. Hermann, Handbuch der Leiterplattentechnik, Kapitel 17, 2. Auflage, Eugen G. Lenze Verlag, Saulgau, 1982, beschrieben.

Die auf diese Art hergestellten Metallkernleiterplatten weisen besondere Schwachstellen in den Durchkontaktierungen auf.

Der Erfindung liegt die Aufgabe zugrunde, ein Verfahren zur Herstellung einer Metallkernleiterplatte, sowie die Metallkernleiterplatte selbst, bereitzustellen, wobei die Durchkontaktierungen zuverlässig ausgebildet sind.

Diese Aufgabe wird gemäß der kennzeichnenden Teile der Ansprüche 1 und 11 gelöst. Vorteilhafte Ausführungsformen und Weiterbildungen der Erfindung sind in den Unteransprüchen enthalten.

Der wesentliche Vorteil der Erfindung besteht darin, daß die Zahl der Verarbeitungsschritte vermindert wird und der genannte Nachteil nicht auftritt. Außerdem sind an den Durchkontaktierungen geschlossene Kunststoffoberflächen vorhanden, so daß eine gleichmäßige Metallisierung der Durchkontaktierungen gewährleistet ist. Nach dem erfindungsgemäßen Verfahren lassen sich Leiterplatten mit isolierter Außenkontur ohne zusätzlichen Aufwand herstellen.

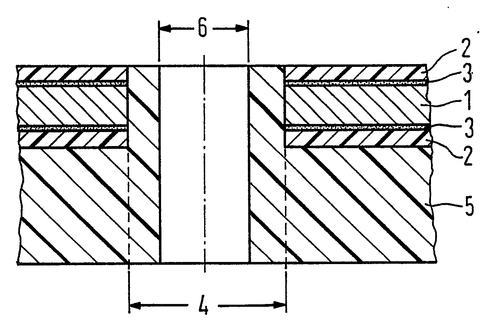

Die Erfindung wird anhand eines Ausführungsbeispiels erläutert, wobei die Figur einen Schnitt durch einen Teil einer erfindungsgemäßen Metallkernleiterplatte zeigt:

Als Metallkern 1 dient ein Aluminiumblech, das in diesem Fall beidseitig mit einer Kunststoffolie 2 kaschiert wird. Zwischen dem Metallkern 1 und der Kunststoffolie 2 ist ein Klebstoff 3 vorgesehen. Das so kaschierte Blech wird gebohrt. Das Einbringen des gewünschten Lochbildes mit entsprechendem Übermaß in die kaschierte Metallplatte kann aber auch durch Stanzen erfolgen. Eine Bohrung ist mit 4 bezeichnet. Danach wird die Leiterplatte einseitig in einem Spritzgußwerkzeug mit einem Kunststoff 5 umspritzt. Dieser Kunststoff 5 ist vorzugsweise ein Thermoplast. Dabei werden die Löcher 4 isoliert und auf das Endmaß 6 ausgefüllt. Durch den Umspritzvorgang wird die Kaschierfolie 2 mit dem Thermoplast 5 an allen Berührungsflächen dicht verschmolzen.

Die Metallkernleiterplatten können zwei- oder dreidimensional sein. Das oben angeführte Spritzgießverfahren ist durch ein Spritzprägeverfahren oder ein Preßverfahren austauschbar. Der Metallkern 1 kann einseitig oder beidseitig mit der Kunststofffolie 2 kaschiert werden und ebenfalls ein- oder beidseitig mit dem Kunststoff 5 beschichtet werden. Als Basis für das Auftragen des Kunststoffes 5 ist jedoch in der Regel eine Kunststoff folie 2 notwendig. Die Auswahl der Materialien ist so gestaltet, daß der Metallkern eine hohe Wärmeleitfähigkeit hat und die Abstimmung der verschiedenen eingesetzten Materialien, d.h. die Kombination von Metallen und Kunststoffen bezüglich des verschiedenen Wärmeausdehnungskoeffizienten der einzelnen Komponenten keine großen Abweichungen beinhalten. Damit soll verhindert werden, daß sich Wärmespannungen, verursacht durch Wärmeausdehungen in oder zwischen verschiedenen Schichten nachteilig auswirken. In der Regel wird der mit der Kunststoffolie vorbereitete Metallkern 1 einer Metallkernleiterplatte innerhalb seiner Löcher 4 und von einer Seite her flächig mit dem Kunststoff 5 umhüllt. Damit kann eine außenliegende und umlaufende Isolation der Leiterplatte gleichzeitig hergestellt werden. Es ist ebenso möglich, den Metallkern 1 nur über einen kleinen Teil der gesamten Leiterplatte zu erstrecken oder den Metallkern 1 nur partiell mittels des Kunststoffes 5 zu beschichten. Das Endmaß der Löcher 4, die mit Übermaß gebohrt oder gestanzt wurden, wird durch Auffüllen mit dem Kunststoff 5 im Thermoformverfahren erhalten, wobei das Endmaß natürlich durch im Werkzeug entsprechend vorhandene Stifte mit dem gewünschten Durchmesser erzielt wird. Prinzipiell können Metallkernleiterplatten mit einem bestimmten Lochbild hergestellt werden. Zum Einsatz als Gehäuseteil oder für die Bestückung mit rein oberflächenmontierbaren Bauteilen ist jedoch mittels dieses erfindungsgemäßen Verfahrens auch eine Metallkernleiterplatte ohne Löcher 4 herstellbar. Die verwendeten Kunststoffe für die Kunststoffolie 2 und dem Kunststoff 5 sind so ausgewählt, daß für beide dasselbe Verfahren zur Metallisierung, zur Herstellung der Leiterbahnen, angewendet werden kann. Wird beispielsweise als Kunststoff für die Kunststoffolie 2 und den Kunststoff 5 die chemische Substanz Polyetherimid verwendet, so lassen sich übliche Galvanisierverfahren, die von verschiedenen Firmen angeboten werden und üblicherweise aus einem oder mehreren Vor behandlungsbädern, sowie einem Hauptbehandlungsbad bestehen, zu dieser Metallisierung von Polyetherimid verwenden. Polyetherimid gehört zur Gruppe der Thermoplasten.

Bezugszeichenliste

    1 Metallkern
    2 Kunststoffolie, kaschiert
    3 Klebstoff
    4 Loch
    5 Kunststoff
    6 Endmaß

**Ansprüche**

1. Verfahren zur Herstellung einer Metallkernleiterplatte, deren Kern aus einem gut wärmeleitfähigen Metall, vorzugsweise Aluminium, Kupfer, Messing oder Stahl besteht, wobei die Wärmeausdehnungskoeffizienten von Metallkern (1) und weiteren Leiterplattenwerkstoffen möglichst gleich sind, **dadurch gekennzeichnet,** daß Metallkernleiterplatten beliebiger Form auf einem Kunststoff (5) in einem Thermoformverfahren hergestellt werden, wobei der Metallkern (1) zumindest einseitig mit einer Kunststoffolie (2) kaschiert wird und dann dieser kaschierte Kern in ein formgebendes Werkzeug eingelegt, zumindest einseitig mit Kunststoff (5) auf der Kunststoffolie (2) umhüllt wird und dabei gleichzeitig in der Leiterplatte vorhandene Löcher auf ihr Endmaß (6) ausgefüllt werden, wobei die endgültige Kontur der Leiterplatte ausgebildet wird.

2. Verfahren nach Anspruch 1, **dadurch gekennzeichnet,** daß sich der Metallkern (1) nur über einen Teil der Leiterplatte erstreckt.

3. Verfahren nach einem der vorhergehenden Ansprüche, **dadurch gekennzeichnet,** daß die Umhüllung mittels Kunststoff (5) nur partiell geschieht.

4. Verfahren nach einem der vorhergehenden Ansprüche, **dadurch gekennzeichnet,** daß als Kunststoff (5) ein Duroplast verwendet wird.

5. Verfahren nach einem der Ansprüche 1 bis 3, **dadurch gekennzeichnet,** daß als Kunststoff (5) ein Thermoplast verwendet wird. .

6. Verfahren nach einem der vorhergehenden Ansprüche, **dadurch gekennzeichnet,** daß die kaschierte Kunststoffolie (2) und der zur Umhüllung dienende Kunststoff (5) aus derselben Kunststoffart bestehen.

7. Verfahren nach einem der vorhergehenden Ansprüche, **dadurch gekennzeichnet,** daß zur Aufbringung der kaschierten Kunststoffolie (2) Klebstoffe (3) in Form von Klebstoffolien verwendet werden.

8. Verfahren nach einem der Ansprüche 1 bis 6, **dadurch gekennzeichnet,** daß zur Aufbringung der kaschierten Kunststoffolie (2) flüssige Klebstoffe (3) verwendet werden.

9. Verfahren nach einem der Ansprüche 7 oder 8, **dadurch gekennzeichnet,** daß die Klebstoffe (3) hochtemperaturbeständig sind.

10. Verfahren nach einem der vorhergehenden Ansprüche, **dadurch gekennzeichnet,** daß die Kunststoffolie (2) ohne Klebstoff (3) durch Walzenkaschierung nach entsprechender Vorbehandlung des Metallkerns (1), zum Beispiel mit einem Haftvermittler oder Treatment, aufgebracht werden.

11. Metallkernleiterplatte deren Kern aus einem gut wärmeleitfähigen Metall besteht und deren Materialien möglichst gleiche Wärmeausdehnungskoeffizienten aufweisen, **gekennzeichnet durch** folgenden Aufbau:
- einen Metallkern (1),
- eine zumindest einseitig auf den Metallkern (1) mittels Klebstoff (3) aufgebrachte Kunststoffolie (2),
- einen zumindest einseitig auf die Kunststoffolie (2) durch ein Thermoformverfahren aufgebrachten Kunststoff (5), wobei der hohlzylindrische Teil an den Löchern (4), die Differenz zwischen den mit Übermaß konstruierten Löchern (4) und deren Endmaß (6), ebenfalls aus dem Kunststoff (5) besteht.